(19) Europäisches Patentamt
European Patent Office
Office européen des brevets

(11) Publication number: **0 182 371**
**A2**

(12) **EUROPEAN PATENT APPLICATION**

(21) Application number: **85114742.1**

(22) Date of filing: **19.11.85**

(51) Int. Cl.⁴: **H 01 L 23/28**, G 11 B 7/24

(30) Priority: **20.11.84 JP 245081/84**

(43) Date of publication of application: **28.05.86**
**Bulletin 86/22**

(84) Designated Contracting States: **DE FR GB**

(71) Applicant: **Matsushita Electric Industrial Co., Ltd., 1006, Oaza Kadoma, Kadoma-shi Osaka-fu, 571 (JP)**

(72) Inventor: **Wasa, Kiyotaka, 7-27, Chiyogaoka 2-chome, Nara City, 631 (JP)**
Inventor: **Hirao, Takashi, 17-14 Shikanodai-kita 3-chome, Ikoma City, 630-01 (JP)**
Inventor: **Nishikawa, Atsuo, 10-27 Nanseidai 4-chome, Katano City, 576 (JP)**
Inventor: **Nishino, Seiji, 1-24, Hannan-cho 6-chome, Abeno-ku Osaka City, 545 (JP)**
Inventor: **Ohta, Takeo, 314-1, Ohmiya-cho 4-chome, Nara City, 630 (JP)**

(74) Representative: **Dr. Elisabeth Jung Dr. Jürgen Schirdewahn Dipl.-Ing. Claus Gernhardt, P.O. Box 40 14 68 Clemensstrasse 30, D-8000 München 40 (DE)**

(54) **Protection film structure for functional devices.**

(57) An inorganic protection film (12) such as of silicon nitride for protecting function devices (16) on the substrate from water molecules (15) is formed on an organic substrate (11) such as of polycarbonate with a soft buffer interface film (13) inbetween, and the buffer film releases stress due to difference of thermal expansion coefficients of the organic substrate and the protection film.

L

15
X
12
13
11
17
14
16

EP 0 182 371 A2

ACTORUM AG

0 182 371

TITLE OF THE INVENTION

Protection film structure for functional devices

FIELD OF THE INVENTION AND RELATED ART STATEMENT

1. FIELD OF THE INVENTION

The present invention relates generally to a protection film structure for functional devices, and particularly to the protection film structure for functional devices which are protected from humidity, for instance, sensor array, memory devices, magnetic recording medium, etc.

2. DESCRIPTION OF THE RELATED ART

Protection film for protecting functional device, functional film structure or functional material has been used to improve reliability of the functional device or the like. For such protection film, hitherto inorganic material such as silicon oxide, glass, etc. and organic material such as polyimido, varilene (trade mark), etc. have been used. These protection films have been used in limited uses of small areas, but recent technology requires protection of large areas of functional devices such as sensor array, recorded disc, recorded tape, etc. to improve resistivity against humidity and abrasion.

Especially, recent development of electronic devices strongly requires forming of a protection film which has different thermal expansion coefficient from that of the substrate, or forming of a uniform protection film under a low temperature such as the room temperature.

However, the conventional art has not been able to provide a satisfactory protection film configuration to the above-mentioned requirements both in characteristic and in economical view point.

The inventors experimentally found a novel constitution of a protection film structure for functional devices which can satisfactorily fulfil the above-mentioned requirements.

OBJECT AND SUMMARY OF THE INVENTION

The primary purpose of the present invention is to provide a protection film structure having a high mechanical strength and capable of certainly protecting substrate and functional devices from humidity.

Another purpose of the present invention is to provide a protection film structure capable of protecting a substrate having functional devices thereon, which has high bonding force and high resistivity against humidity.

Still another purpose of the present invention is to provide a protection film structure for protecting functional devices successfully formed on a substrate by providing dense and mechanically strong protection film of different thermal expansion coefficient and hardness on an organic substrate by forming a buffer film inbetween.

Still another purpose of the present invention is to provide a protection film structure for functional devices formed on an organic substrate, capable of having high reliability.

The protection film structure for functional devices in accordance with the present invention comprises

an inorganaic humidity protection film formed on a substrate and

a buffer film formed between the substrate and the inorganic humidity protection film, the buffer film being for releasing stress due to difference of thermal expansion coefficients of the substrate and the inorganic protection film.

BRIEF DESCRIPTION OF THE DRAWINGS

FIG.1 is a sectional view of a first preferred embodiment in accordance with the present invention.

FIG.2 is a sectional view of another preferred embodiment in accordance with the present invention.

FIG.3 is a graph showing time change of humidity-resistivity characteristic of the embodiments in accordance with the present invention.

FIG.4 is a sectional view of still another embodiment in accordance with the present invention.

FIG.5 is a sectional view of still another embodiment in accordance with the present invention.

DESCRIPTION OF THE PREFERRED EMBODIMENTS

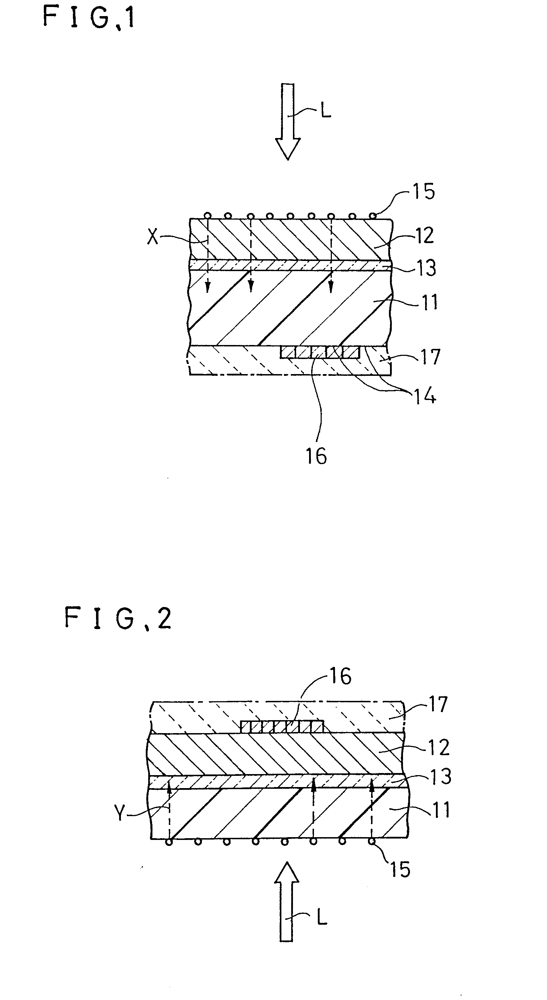

A first preferred embodiment in accordance with the present invention is shown in FIG.1 which is a sectional view of a protection film structure for functional devices of the present invention. As shown in FIG.1, one surface of a substrate 11 of an organic material is covered by a protection film 12 with a bond film 13 which serves as a buffer layer inbetween. On the other surface 14 of the substrate 11, known functional devices 16, such as photosensor film, etc. are formed. A while arrow L shows light to impinge on the functional device 16.

According to the above-mentioned configuration and constitution, the water molecule 15 coming into the sensor thin film 16 through the substrate is prevented from its intrusion by the protection film 12. Of course, a known passivation film 17 may be formed to protect the rear side of the functional device thin film 16. In other modification, two sets of the above-mentioned configuration may be bonded in a manner that the photosensor thin films 16, 16 are facing each other with a suitable adhesive film inbetween.

In the above-mentioned configuration, for the material of the substrate, organic materials such as film shape or sheet shape acrylate polystyrene, polycarbonate, polyethylene, polyester, vinyl chloride, etc. are used for the sake of their easiness of forming and their plasticity. The substrate comprising the above-mentioned materials generally contains water molecules therein and has a characteristic to pass them, and so, there is a necessity of taking utmost measure to prevent intrusion of the water molecules to the function devices 16 through the substrate 11 of organic material in order to avoid deterioration due to the water molecules. Accordingly, in order to improve the humidity-resistivity in such configuration, there is necessity of providing a protection film 12 on the substrate 11 to prevent the intrusion of water molecule to the function devices 16. And such protection film 12 must have large mechanical strength in view of mechanical protection of the functional devices.

In accordance with the above-mentioned reasons, as the protection film 12 to be formed on the substrate 11, in the view points of humidity-resistivity and mechanical strength, a protection film of inorganic material is much appropriate than a film of organic material, and by utilization of such strong inorganic film as the protection film structure, intrusion of the water molecules as shown by small arrows X, X ... of FIG.1 into the substrate 11 is prevented.

In the above-mentioned configuration, if an inorganic protection film such as quartz glass is used, because of large difference of thermal expansion coefficients and mechanical strengths between the substrate 11 and the protection film 12, a considerable stress is generated therebetween, thereby to break the protection film 12 or make cracks thereon and results in poor and impractical bonding force.

Hitherto, in an art of forming the inorganic protection film on an organic material substrate has been used in such cases as forming aluminum metal film on a resin substrate by forming organic film as a bonding film inbetween. Though the aluminum, which is a soft material among the inorganic material is easily bonded on the organic material substrate, a very much harder material, such as silicon niride or silicon carbide as protection film are considered to be hardly bonded on an organic material substrate.

However, the inventors found that a protection film structure having high and effective bonding force and humidity resistive characteristic and strong mechanical force can be formed by providing a buffer film 13 between the substrate 11 and the protection film 12, so that stress due to difference of thermal expansion coefficients between the substrate 11 and the protection film 12 is relieved and the crack or breakdown of the protection film can be avoided thereby making the inorganic protection film practically usable.

That is the inventors found that when a thin film of polyurethan is used as the bond film 13 to serve as a buffer film and silicon nitride or silicon oxinitride containing oxygen atoms as the protection film 12, water molecule absorption of an organic substrate 11 in humid atmosphere very much decreases. Since heat resistivity of the organic substrate 11 is such low as about 100°C, the forming of inorganic protection film 12 of silicon nitride thin film is made by sputtering or plasma CVD method wherein the protection film is made under 100°C. The silicon nitride thin film is amorphous, and chemical compound thereof need not be $Si_3N_4$ which is widely used in the semiconductor IC manufacturing process, but only inclusion of silicon-nitrogen compound as its component is sufficient, and excessive containment of either of silicon or nitrogen is not a problem.

As the bond film 13 which serves as the buffer film, a silicon oxide film may be used. For instance, the inventors found that when silicon oxide film of 100 Å or thinner is formed as the buffer film 13 and silicon nitride film 12 is formed thereafter resulted in improvement by 50 % of bonding force in comparison with another case wherein silicon nitride protection film 12 is directly formed by plasma CVD process on the substrate 11 of polycarbonate. For instance, the tensile strength of the former (embodiment) was 315 $g/mm^2$ while that of the latter was 135 $g/mm^2$. The thickness of the bonding film 13 of the embodiment was about 0.1--10 µm, and it is found that when the thickness becomes more than 10 µm the surface of the protection film 12 loses evenness and lack of utility, and when the thickness becomes smaller than 0.1 µm the forming of the bonding film 13 becomes inuniform though not fatally defective for utility. Requirement of the bonding film 13 is a property of being softer than the substrate 11, having a large flexibility and having good wetting with the protection film 12 is preferable, and as a material of the bond film 13 a wide range of organic material other than the polyurethan resins may be used.

Furthermore, as shown in FIG.2, the protection film structure for functional devices in accordance with the present invention can be formed between the organic substrate 11 and the functional devices 16 so that water molecules passing through the organic substrate 11 can be presented by the protection film 12. That is, in this case of FIG.2, the humidity which comes through the substrate 11 is prevented from reaching the functional devices 16 formed on the protection film 12.

Concrete embodiments of the present invention are described hereafter.

EXAMPLE 1

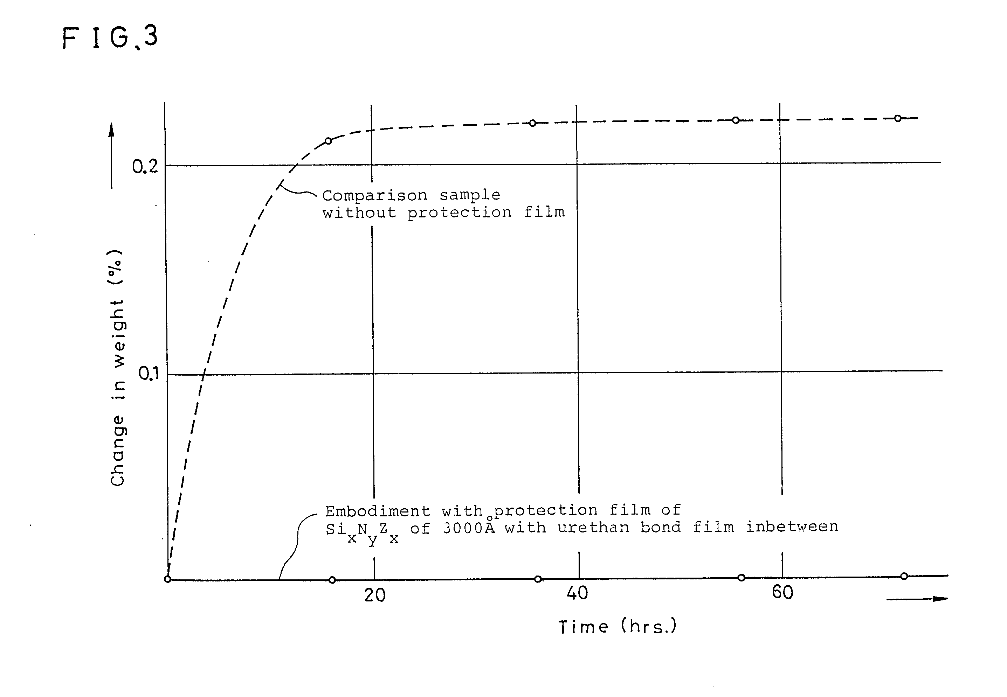

A polycarbonate substrate having a flat front face and a flat rear face and 5 mm thickness is used as the substrate 11. The substrate is heat-treated at 90°C for 10 hrs. to remove water molecules therein and on the surfaces. This heat treatment is important in certainly and reliably forming a bonding layer 13 and a protection layer 12 thereon. On all the front face of the heat-treated substrate 11, a thermo hardening polyurethan resin is formed by spin-coating method to a thickness of 2 μm, and thereafter heat treatment is made at 80°C for 10 hrs. to harden the polyurethan resin film, thereby to form the bonding film 13. Then by means of known plasma CVD process, the protection film 12 of silicon nitride thin film of 0.3 μm thickness is formed keeping the substrate at 80°C, thereby to form the protection film 12. Then the polycarbonate substrate with the protection film is put in a warm humid atmosphere of 80°C and 85 % RH for 50 hrs, and the resultant sample is compared with a comparison sample which has no protection film 12 but left in the same condition. The water absorption characteristics of the above-mentioned embodiment and the comparison sample are shown in FIG.3, wherein the embodiment with the protection film has less than 0.01 % of water absorption as shown by a curve plotted with white circles and the comparison sample without the protection film shows absorption of over 0.2 % as shown by a curve plotted by black circles.

EXAMPLE 2

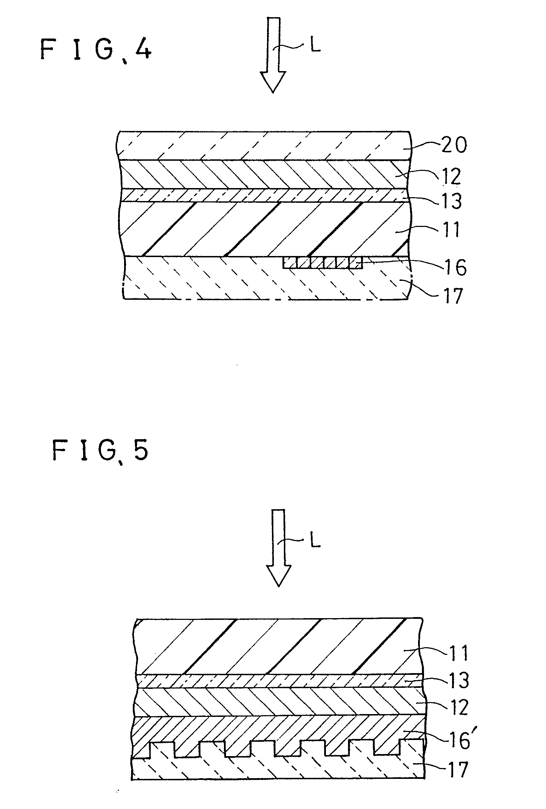

First, by means of the process elucidated in EXAMPLE 1 with reference to FIG.4, on an organic resin substrate 11 of polycarbonate, a protection film 12 of inorganic substance such as silicon nitride is formed with a buffer film 13 of a plastic resin such as polyurethan resin 13, and further on the surface of the inorganic protection film 12 an inorganic water repulsive surface film, such as silicon carbide thin film 20 of about 100 Å thickness, is formed by known plasma CVD method, by keeping the underlying protection film 12 at 80°C. Electron beam diffraction image shows that the silicon carbide thin film 20 was amorphous and that an infrared absorption spectrum showing bonding between silicon and carbon was observed. When electric resistance of the surface was measured in warm and humid atmosphere by retaining the resultant compound protection film in an atmosphere of 90°C and 95 % RH for a considerable time, no change from dry state was observed and satisfactory water repulsive characteristic was observed. Change of water molecule absorption by the polycarbonate substrate in the warm and humid atmosphere showed a very small value which is less than $\frac{1}{2}$ of the value where the silicon carbide surface film 20 was not provided.

As can be understood from the above-mentioned embodiments, the protection film structure in accordance with the present invention enables effective bonding of the inorganic protection film 12 or composite protection film 12+20 on the organic material substrate 11 and can increase humidity-resistivity, and furthermore, the obtained protection film 12 is dense and mechanically strong.

Since the optimum value of thickness of the protection film 12 is dependent on the functional devices 16 formed on the organic substrate 11, the thickness is not necessarily limited to the range of the above-mentioned embodiments.

For the protection film 12, any composition having a chemical composition principally of nitride of silicon and besides containing oxygen and carbon may be used and similar effect to that of the silicon nitride is obtainable. In such modified protection film, it is better to increase oxygen concentration so as to make oxide of silicon a principal component at the vicinity of the interface between the protection film 12 and bonding film 13, to increase bonding force. The inventors also confirmed that when the protection film is very thin, for instance, between about 100 Å and about 0.3 μm, the oxide of silicon serves the function of the bonding film 13. Besides it is experimentally confirmed that hardness of the bonding film 13 serving as the buffer film should be smaller than that of the protection film 12.

Besides the above-mentioned oxide of silicon, tin oxide, indium oxide, plumbium oxide, titanium oxide, or the like metal oxides are effective as the bonding film 13.

Apart from the above-mentioned examples where substrate 11 is of organic material, in case water repulsive surface films are provided constituting the protection film as composite protection film, the present invention is also effective for such cases that the substrate is metal, semiconductor, glass, ceramics or the like inorganic materials.

Protection film structure for functional devices in accordance with the present invention is widely applicable for not only semiconductor devices or electronics components, but also for optical disk, optomagneto memory sheet, magnetic tape, optoelectric sensor array, or the like devices having large areas to be protected by the protection film, and the utility of the invention is very high.

One example of application of this invention to an optical disk is shown in FIG.5, wherein on a substrate of organic material of polycarbonate disk, an inorganaic protection layer 12 of silicon nitride or silicon carbide is provided with a buffer film 13 of oxide of silicon, and on the protection film 12 a recording film 16' having data recording grooves and made of $TeO_x$ or TeC as the function device, are provided, and further thereon, a known passivation film 17 is provided. This optical device is used by irradiating light L from the surface of the substrate 11. The optical disk has a stable performance since the surface of the optical groove is protected by the strong inorganic protection film 12.

WHAT IS CLAIMED IS:

1. A protection film structure for functional devices comprising

an inorganic humidity protection film (12) formed on a substrate (11) and

a buffer film (13) formed between said substrate (11) and said inorganic humidity protection film (12), said buffer film (13) being for releasing stress due to difference of thermal expansion coefficients of said substrate and said inorganic protection film.

2. A protection film structure for functional devices in accordance with claim 1, wherein

said buffer (13) film has a larger flexibility than that of said substrate.

3. A protection film structure for functional devices in accordance with claim 1, wherein

said buffer film (13) is silicon oxide.

4. A protection film structure for functional devices in accordance with claim 1, wherein

said protection film (12) is of one substance selected from a group consisting of silicon nitride, silicon oxinitride and silicon carbide.

5. A protection film structure for functional devices in accordance with claim 1, wherein

hardness of said buffer film (13) is smaller at least than that of said protection film (12).

6. A protection film structure for functional devices in accordance with claim 1, wherein

said substrate (11) is of a substance selected from a group consisting of acrylatepolystyrene, polycarbonate, polyester, polyethilene and vinyl chloride.

7. A protection film structure for functional devices in accordance with claim 1, which further comprises

a water-repulsive film (20) on said protection film (12).

8. A protection film structure for functional devices in accordance with claim 1, wherein

said buffer film (13) is of transparent inorganic film such as indium oxide or tin oxide.

9. A protection film structure for functional devices in accordance with claim 1, wherein

said protection film (12) is further coated with an overriding organic film.

10. A protection film structure for functional devices in accordance with claim 1, wherein

said organic substrate is of polycarbonate and

said protection film is of low-temperature-plasma-CVD silicon nitride or of low-temperature-plasma-CVD silicon oxinitride.

11. Method for forming protection film structure comprising the steps of

forming a buffer film (13) on a substrate (11) and

forming an inorganic protection film (12) on said buffer film (13),

said buffer film having such hardness to release stress due to difference of thermal expansion coefficients of said substrate and said protection film.

12. Method in accordance with claim 1, wherein

said substrate (11) is an organic substrate and

said substrate (11) has been heat-treated for dehydration prior to said forming of said buffer film (13).

FIG.1

L
15
X
12
13
11
17
14
16

FIG.2

16
17
12
13
Y
11
15
L

Change in weight (%)
0.2
0.1
Comparison sample
without protection film
Embodiment with protection film of
$Si_xN_yZ_x$ of 3000Å with urethan bond film inbetween
20
40
60
Time (hrs.)

FIG.3

FIG. 4

L

20
12
13
11
16
17

FIG. 5

L

11
13
12
16′
17